# EUROPEAN PATENT APPLICATION

(11) **EP 1 669 418 A1**
(43) Date of publication of application: **14.06.2006**
(21) Application number: 03778880.9
(22) Date of filing: 12.12.2003
(51) Int. Cl.: C09C 1/02, C01F 5/02, C08K 9/02, C08L 101/00

(54) **SPHERICAL COATED MAGNESIUM OXIDE POWDER AND METHOD FOR PRODUCTION THEREOF, AND RESIN COMPOSITION COMPRISING THE POWDER**

(30) Priority: 03.10.2003 JP 2003346083
(71) Applicant: TATEHO CHEMICAL INDUSTRIES CO., LTD., Ako-shi, Hyogo 678-0239 (JP)
(72) Inventor: KIYOKAWA, T., Tateho Chemical Industries Co., Ltd., Ako-shi, Hyogo 678-0239 (JP); YAMAMOTO, K., Tateho Chemical Industries Co., Ltd., Ako-shi, Hyogo 678-0239 (JP); KUNISHIGE, M., Tateho Chemical Industries Co., Ltd, Ako-shi, Hyogo 678-0239 (JP)
(74) Representative: Becker Kurig Straus
(86) International application number: PCT/JP2003/015953
(87) International publication number: WO 2005/033215

(57) **Abstract**

Provided is a sphere-shaped coated magnesium oxide powder having a surface coated with a double oxide and having an average shape factor of 1.25 or less, wherein the powder is advantageous not only in that it has excellent humidity resistance, but also in that it has excellent filling property and excellent flowability when being used as filler for a resin.

In addition, provided is a method for producing a sphere-shaped coated magnesium oxide powder, wherein the method comprises allowing a compound of an element forming a double oxide to be present on the surface of magnesium oxide powder, and then fusing the resultant magnesium oxide powder at a high temperature so that the surface of the magnesium oxide powder is coated with the double oxide and the magnesium oxide powder is shaped into sphere.

Further, provided are a resin composition comprising the sphere-shaped coated magnesium oxide powder and an electronic device using the resin composition.

## Description

### Field of the Invention

The present invention relates to a sphere-shaped coated magnesium oxide powder having excellent humidity resistance and excellent filling property when being used as filler, and a method for producing the same. The present invention is also concerned with a resin composition comprising the sphere-shaped coated magnesium oxide powder and an electronic device using the resin composition.

### Background of the Invention

An electronic device is consisted of electronic components, such as a laminate, a printed wiring board, and a multilayer wiring board. In electronic components, generally, a resin composition is used in a prepreg, a spacer, a sealer, or an adhesive sheet, and the resin composition is required to have various performance and properties. For example, recently, an electronic device tends to have a large-capacity power element mounted or have elements mounted with high density, and therefore, a resin composition used in the electronic device and a material formed from the resin composition are required to have more excellent heat radiating property and humidity resistance than those of conventional ones.

As filler for use in a semiconductor sealing resin composition, silicon dioxide (hereinafter, referred to as "silica") and aluminum oxide (hereinafter, referred to as "alumina") have conventionally been used. However, silica has low thermal conductivity, and hence cannot satisfactorily remove from the semiconductor a large amount of heat generated due to the increase of the integration degree, power, or speed of the device, thus causing a problem of the stable operation of the semiconductor. On the other hand, when using alumina having thermal conductivity higher than that of silica, the heat radiating property is improved; however, alumina, which has high hardness, poses a problem in that it considerably wears a kneader, a molding machine, or a mold.

For solving the problems, with respect to the material for the filler for use in semiconductor sealing resin, studies are made on magnesium oxide having thermal conductivity which is higher than that of silica by one order of magnitude and substantially equivalent to that of alumina. However, the magnesium oxide powder has high moisture absorption, as compared to the silica powder. Therefore, when the magnesium oxide powder is used as filler for semiconductor sealing resin, hydration occurs between the water absorbed and magnesium oxide, leading to problems in that the filler increases in volume to cause cracks, and that the thermal conductivity is lowered. For this reason, for surely achieving a stable operation of the semiconductor for a long term, it is important to impart a humidity resistance to the magnesium oxide powder used as filler for semiconductor sealing resin.

As a method for obtaining magnesium oxide powder having an improved humidity resistance, Japanese Unexamined Patent Publication Nos. 2003-34522 and 2003-34523 disclose a method for producing coated magnesium oxide powder, wherein the method comprises mixing an aluminum salt or a silicon compound with magnesium oxide powder, and collecting solids by filtration and drying and calcining the solids so that the surface of the magnesium oxide powder is coated with a coating layer comprising a double oxide of aluminum or silicon and magnesium.

The coated magnesium oxide powder obtained by the above method is improved in humidity resistance, but the particles of the powder have angular shapes and hence have low filling property for a resin, and further there is a problem in that the resultant resin composition has low flowability.

On the other hand, Japanese Patent No. 2590491 discloses a method for producing a magnesium oxide-material, in which alumina and/or silica particles are added to magnesium oxide powder, and the resultant mixture is granulated using a spray dryer to obtain a sphere-shaped granulated material, and then at least part of the granulated material is fused without destroying the granulated state, followed by quenching.

This method is intended to improve the magnesium oxide powder in humidity resistance, but the sphere-shaped granulated material obtained by granulation using a spray dryer is an aggregate of particles, that is, a porous material, and therefore it is expected that the granulated material is difficult to fill a resin with high density.

It is an object of the present invention to solve the above problems and to provide a sphere-shaped coated magnesium oxide powder which is advantageous not only in that it has excellent humidity resistance and excellent filling property when being used as filler for a resin, but also in that the resin composition containing the powder has high flowability and hence is excellent in moldability. It is another object of the present invention to provide a method by which the sphere-shaped coated magnesium oxide powder can be easily produced, and a resin composition comprising the sphere-shaped coated magnesium oxide powder and an electronic device using the resin composition.

### Disclosure of the Invention

For attaining the above objects, the present inventors have made extensive and intensive studies on the shape of a coated magnesium oxide powder in respect of an average shape factor of powder particles. As a result, it has been found that the average shape factor has an optimal range, and thus the present invention has been completed.

Further, it has been found that a sphere-shaped coated magnesium oxide powder can be easily produced by a method in which a compound of an element forming a double oxide having a melting point of 2,773 K or lower is allowed to be present on the surface of magnesium oxide powder and the resultant magnesium oxide powder is fused at a high temperature.

Specifically, in the present invention, there is provided a sphere-shaped coated magnesium oxide powder having a surface coated with a double oxide and having an average shape factor of 1.25 or less.

In addition, in the present invention, there is provided a method for producing a sphere-shaped coated magnesium oxide powder, wherein the method comprises allowing a compound of an element forming a double oxide to be present on the surface of magnesium oxide powder, and then fusing the resultant magnesium oxide powder at a high temperature so that the surface of the magnesium oxide powder is coated with the double oxide and the magnesium oxide powder is shaped into sphere.

Further, in the present invention, there are provided a resin composition comprising the above sphere-shaped coated magnesium oxide powder and an electronic device using the resin composition.

### Best mode for carrying out the Invention

### Sphere-shaped coated magnesium oxide powder

The sphere-shaped coated magnesium oxide powder of the present invention has a surface coated with a double oxide and has an average shape factor of 1.25 or less.

The shape factor is a value determined with respect to a projected image of particles and represented by the formula: (Circumference length)²/{4π × (Sum of areas)} . The shape factor indicates that the value is 1 when the projected image of particles is precisely a circle, and that the value is larger when the projected image has an irregular form.

The average shape factor employed in the present invention is an average value of the shape factors of 100 particles determined using a laser microscope and an image analysis software.

For increasing the rate of the powder filling a resin, it is required that the shape of the powder be as spherical as possible. In the present invention, it is necessary that the sphere-shaped coated magnesium oxide powder have an average shape factor of 1.25 or less, and the powder preferably has an average shape factor of 1.22 or less, more preferably 1.20 or less. The powder having an average shape factor of 1.25 or less is improved in the filling property for a resin, and further the resultant resin composition has excellent flowability.

The sphere-shaped coated magnesium oxide powder of the present invention has a surface coated with a double oxide. The first purpose of the coating with a double oxide is to improve the humidity resistance of the magnesium oxide powder, and the second purpose is to facilitate the step for causing the magnesium oxide powder to be shaped into sphere. Specifically, a double oxide having a melting point lower than the flame temperature is formed on the surface of the magnesium oxide powder to lower the melting point of the surface of the magnesium oxide powder, thus making it easy to cause the powder to be shaped into sphere. The melting point of the double oxide is preferably 2,773 K or lower, more preferably 2,273 K or lower.

It is preferred that the double oxide coating the surface of the magnesium oxide powder comprises at least one element selected from the group consisting of aluminum, iron, silicon, and titanium, and magnesium. Examples of double oxides include forsterite (Mg₂SiO₄), spinel (Al₂MgO₄), magnesium ferrite (Fe₂MgO₄), and magnesium titanate (MgTiO₃).

The amount of the double oxide used in the present invention, that is, the amount of the double oxide present on the surface per one particle is preferably 5 to 50 mass%, more preferably 10 to 40 mass%. When the amount of the double oxide falls in the above range, the surface of the magnesium oxide powder is completely coated with the double oxide and hence the powder is easily shaped into sphere, so that the resultant powder can fill a resin with high density, and further the resin composition containing the powder has such high thermal conductivity that it can exhibit satisfactory effects of thermal conductive filler.

The sphere-shaped coated magnesium oxide powder of the present invention preferably has an average particle size of 5 × 10⁻⁶ to 500 × 10⁻⁶ m, more preferably 10 × 10⁻⁶ to 100 × 10⁻⁶ m. The sphere-shaped coated magnesium oxide powder preferably has a BET specific surface area of 5.0 × 10³ m²/kg or less, more preferably 1 × 10³ m²/kg or less.

### Method for producing a sphere-shaped coated magnesium oxide powder

The sphere-shaped coated magnesium oxide powder of the present invention is produced by allowing a compound of an element forming a double oxide to be present on the surface of magnesium oxide powder, and then fusing the resultant magnesium oxide powder at a high temperature so that the surface of the magnesium oxide powder is coated with the double oxide and the magnesium oxide powder is shaped into sphere.

Generally, as a method for obtaining powder having a particle shape as spherical as possible, for example, a method is used in which powder is passed through a flame at a high temperature and fused and shaped into sphere due to a surface tension. This method can be applied to silica or alumina having a melting point lower than the flame temperature (2,073 to 2,723 K) caused by burning of oxygen, but the method cannot be applied to magnesium oxide having a melting point higher than the flame temperature (melting point: 3,073 K), and therefore it has been considered that this method is difficult to cause the magnesium oxide to be shaped into sphere.

In the method of the present invention, a double oxide having a melting point lower than the flame temperature is formed on the surface of magnesium oxide powder to lower the melting point of the surface of the magnesium oxide powder, and therefore the above-mentioned high-temperature flame fusion process can be applied to cause the magnesium oxide powder to be shaped into sphere. The double oxide preferably has a melting point of 2,773 K or lower, more preferably 2,273 K or lower.

It is preferred that the compound used for forming a double oxide is at least one compound selected from the group consisting of an aluminum compound, an iron compound, a silicon compound, and a titanium compound. The form of the compound is not limited, but a nitrate, a sulfate, a chloride, an oxynitrate, an oxysulfate, an oxychloride, a hydroxide, or an oxide is used.

It is preferred that the amount of the compound incorporated into the magnesium oxide powder is determined so that the content of the double oxide in the sphere-shaped coated magnesium oxide powder finally obtained becomes 5 to 50 mass%.

When, for example, a silicon compound is used as the compound of an element forming a double oxide, the sphere-shaped coated magnesium oxide powder can be produced by a method in which fumed silica and magnesium oxide powder are wet-blended together, and filtered and then dried to obtain magnesium oxide powder on which surface silica is uniformly adsorbed, and the powder obtained is passed through a flame of, e.g., propane-oxygen using oxygen as carrier gas, and cooled and then collected by means of a collector. The combustible gas is not limited, but combustible gas, such as propane, butane, acetylene, or hydrogen, or mixed gas thereof can be used.

The magnesium oxide powder used in the present invention preferably has a crystallite size of 50 × 10⁻⁹ m or more. The magnesium oxide powder having a crystallite size of 50 × 10⁻⁹ m or more has low reactivity, as compared to more finely divided powder, and hence, e.g., a silicon compound can be uniformly adsorbed on the surface of the magnesium oxide powder, thus causing the particles of powder to be uniformly shaped into sphere. Further, the surface of the magnesium oxide powder can be uniformly coated with a double oxide, improving the powder in humidity resistance.

The crystallite size employed in the present invention is a value determined from a Scherrer equation using X-ray diffractometry. Generally, an individual particle is a polycrystal comprised of a plurality of single crystals, and a crystallite size means an average of the sizes of single crystals constituting the polycrystal.

With respect to the purity of the magnesium oxide powder, there is no particular limitation, and it is preferred to determine the purity depending on the use of the powder. For example, for meeting the insulating properties of electronic components, the magnesium oxide powder preferably has a purity of 90% or more, more preferably a purity of 95% or more. The magnesium oxide powder having the properties in the present invention can be produced using a known process to a person skilled in the art, e.g., a fusion process or a sintering process.

By the above-described production method, a sphere-shaped coated magnesium oxide powder having high filling property for a resin can be easily obtained at low cost while maintaining excellent humidity resistance and excellent thermal conductivity. In addition, a resin composition comprising the thus obtained sphere-shaped coated magnesium oxide powder has excellent flowability and improved moldability.

In the method of the present invention, the step of fusing and causing the magnesium oxide powder to be shaped into sphere is not limited to the above flame fusion step, and a step that can achieve a desired temperature, for example, a plasma heating step can be used.

### Resin composition comprising the coated magnesium oxide powder

The resin composition of the present invention is obtained by adding the above-described sphere-shaped coated magnesium oxide powder to a resin.

In this case, if necessary, the sphere-shaped coated magnesium oxide powder of the present invention can be subjected to surface treatment with a silane coupling agent, a titanate coupling agent, or an aluminate coupling agent, making it possible to further improve the filling property.

Examples of silane coupling agents include vinyltrichlorosilane, vinyltrialkoxysilane, glycidoxypropyltrialkoxysilane, and methacroxypropylmethyldialkoxysilane.

Examples of titanate coupling agents include isopropyl triisostearoyltitanate, tetraoctyl bis(ditridecylphosphite)titanate, and bis(dioctyl pyrophosphate) oxyacetate titanate.

With respect to the resin used in the resin composition of the present invention, there is no particular limitation, and examples include thermosetting resins, such as epoxy resins, phenolic resins, polyimide resins, polyester resins, and silicone resins, and thermoplastic resins, such as polycarbonate resins, acrylic resins, polyphenylene sulfide resins, and fluororesins. Of these, preferred are epoxy resins, silicone resins, and polyphenylene sulfide resins. If necessary, a curing agent or a curing accelerator can be added.

Examples of epoxy resins include bisphenol A epoxy resins, novolak epoxy resins, bisphenol F epoxy resins, brominated epoxy resins, ortho-cresol novolak epoxy resins, glycidyl ester resins, glycidyl amine resins, and heterocyclic epoxy resins.

Examples of phenolic resins include novolak phenolic resins and resol phenolic resins.

Examples of silicone resins include millable silicone rubbers, condensed liquid silicone rubbers, addition liquid silicone rubbers, and UV curing silicone rubbers, and preferred are addition liquid silicone rubbers. Any of one-pack silicone rubbers and two-pack silicone rubbers may be used, but preferred are two-pack silicone rubbers.

In the resin composition of the present invention, in addition to the sphere-shaped coated magnesium oxide powder, other filler can be added. With respect to the other filler, there is no particular limitation, and examples include fused silica and crystalline silica. If necessary, a lubricant, a flame retardant, a coloring agent, or a low-stress imparting agent can be appropriately added.

The electronic device of the present invention uses the above-described resin composition in its part, and has excellent heat radiating property and excellent humidity resistance. Examples of electronic devices include a resin circuit board, a metal base circuit board, a metal-clad laminate, and a metal-clad laminate having an inner circuit.

Examples of uses of the resin composition of the present invention in the above electronic devices include a semiconductor sealer, a bonding agent, an adhesive sheet, a radiating sheet, a radiating spacer, and a radiating grease.

In the production of the above board using the resin composition of the present invention, a paper substrate or a glass substrate is immersed in the resin composition of the present invention, and dried by heating to cure the resin into a B-stage, forming a prepreg (such as resin cloth or resin paper).

Further, using the prepreg, a resin circuit board, a metal-clad laminate, or a metal-clad laminate having an inner circuit can be produced. For example, a metal-clad laminate is produced by a process in which prepregs are stacked on one another so that a desired thickness of the board is obtained, and metal foils are placed, and the resultant stacked material is sandwiched between molds and inserted into a platen of a pressing machine and subjected to predetermined heating and pressing to obtain a laminated board molded, and the four sides of the laminated board molded are cut off, followed by appearance inspection. The resin composition of the present invention can be used as a substrate in the form of a composite material, such as glass-epoxy or Teflon-epoxy, obtained by mixing the resin composition with another material for substrate.

The resin composition of the present invention can be used as a sealer. The sealing resin is a resin material used in packaging for protecting a semiconductor chip from an external factor, such as a mechanical or thermal stress, or humidity, and the performance of a package formed from the resin composition of the present invention is ascribed to the thermal conductivity and weathering resistance of the cured resin.

The resin composition of the present invention can be used as a bonding agent. The bonding agent is a substance used for bonding two objects together, and, with respect to the material for an object to be bonded, there is no particular limitation. The bonding agent temporarily has flowability when applied to or engaged with the surface of an object to be bonded, and loses the flowability and is solidified after used for bonding. Examples of bonding agents include a solvent-type bonding agent, a pressure-sensitive bonding agent, a heat-sensitive bonding agent, such as an adhesive sheet, and a reactive bonding agent. When the resin composition of the present invention is used as a bonding agent, the thermal conductivity and weathering resistance of the resin composition after used for bonding are ascribed to the thermal conductivity and weathering resistance of the cured resin.

The resin composition of the present invention can be used as a bonding agent to produce a metal base circuit board. The metal base circuit board is produced by a process in which a bonding agent is applied to a metal plate, and a metal foil is stacked on the bonding agent in a B-stage, and the resultant stacked material is integrated by predetermined heating and pressing.

The resin composition of the present invention can be used as a radiator. Examples of radiators include a radiating sheet, a radiating spacer, and a radiating grease. The radiating sheet is an electrical insulating, thermal conductive sheet used for removing heat generated from a heating electronic component or electronic device, and it is produced by adding thermal conductive filler to a silicone rubber, and mainly used in the form of being fitted to a radiating fin or a metal plate. The radiating grease is substantially similar to the radiating sheet except that silicone oil is used instead of the silicone rubber. The radiating spacer is a silicone solid which directly transfers heat generated from a heating electronic component or electronic device to, e.g., a casing for electronic apparatus, and which has a thickness corresponding to the space between the heating electronic component or electronic device and the casing.

### Examples

The present invention will be described in more detail with reference to the following Examples, which should not be construed as limiting the scope of the present invention.

### 1. Sphere-shaped coated magnesium oxide powder

### Synthesis Example 1

Magnesium oxide powder (KMAO-H, manufactured by Tateho Chemical Industries Co., Ltd.), which is an aggregate of single crystals having a crystallite size of 58.3 × 10⁻⁹ m, was ground using an impact grinder into a particle size of 100 × 10⁻⁶ m or less. Fumed silica (purity: 99.9% or more; specific surface area: 200±20 m²/g) was wet-blended with the ground powder so that the amount of the fumed silica became 10 mass%, based on the mass of magnesium oxide, and they were mixed with each other by stirring at 400 to 500 rpm for 600 s. After the stirring, the resultant mixture was subjected to filtration and dehydration to obtain a cake, and the cake was dried overnight using a dryer at 423 K. The dried cake was milled by means of a sample mill while controlling the particle size of the resultant powder to be similar to that of the magnesium oxide powder as a raw material, obtaining a coated magnesium oxide powder.

### Synthesis Example 2

A coated magnesium oxide powder was obtained in substantially the same manner as in Synthesis Example 1 except that the amount of the fumed silica was changed to 3 mass%.

### Synthesis Example 3

A coated magnesium oxide powder was obtained in substantially the same manner as in Synthesis Example 1 except that the amount of the fumed silica was changed to 30 mass%.

### Synthesis Example 4

Magnesium oxide powder (KMAO-H, manufactured by Tateho Chemical Industries Co., Ltd.), which is an aggregate of single crystals having a crystallite size of 58.3 × 10⁻⁹ m, was ground using an impact grinder into a particle size of 100 × 10⁻⁶ m or less. A 4% aqueous solution of aluminum nitrate (a special grade reagent, manufactured by Kanto Chemical Co., Inc.) was wet-blended with the ground powder so that the amount of Al₂O₃ became 10 mass%, based on the mass of magnesium oxide, and they were mixed with each other by stirring at 400 to 500 rpm for 600 s. After the stirring, the resultant mixture was subjected to filtration and a cake being formed was satisfactorily washed with water to remove the residual aluminum nitrate, and then dehydrated to obtain a cake, and the cake was dried overnight using a dryer at 423 K. The dried cake was milled by means of a sample mill while controlling the particle size of the resultant powder to be similar to that of the magnesium oxide powder as a raw material, obtaining a coated magnesium oxide powder.

### Synthesis Example 5

A coated magnesium oxide powder was obtained in substantially the same manner as in Synthesis Example 4 except that, instead of the aluminum nitrate, an aqueous solution of iron nitrate was added so that the amount of Fe₂O₃ became 15 mass%, based on the mass of magnesium oxide.

### Example 1

The powder prepared in Synthesis Example 1 was fed to a high-temperature flame formed by burning of liquefied propane gas and oxygen to effect a fusing and sphere-shaping treatment, obtaining a sphere-shaped coated magnesium oxide powder coated with forsterite (Mg₂SiO₄).

### Example 2

A fusing and sphere-shaping treatment was conducted in substantially the same manner as in Example 1 except that the powder prepared in Synthesis Example 2 was used, obtaining a sphere-shaped coated magnesium oxide powder coated with forsterite (Mg₂SiO₄).

### Example 3

A fusing and sphere-shaping treatment was conducted in substantially the same manner as in Example 1 except that the powder prepared in Synthesis Example 3 was used, obtaining a sphere-shaped coated magnesium oxide powder coated with forsterite (Mg₂SiO₄).

### Example 4

A fusing and sphere-shaping treatment was conducted in substantially the same manner as in Example 1 except that the powder prepared in Synthesis Example 4 was used, obtaining a sphere-shaped coated magnesium oxide powder coated with spinel (Al₂MgO₄).

### Example 5

A fusing and sphere-shaping treatment was conducted in substantially the same manner as in Example 1 except that the powder prepared in Synthesis Example 5 was used, obtaining a sphere-shaped coated magnesium oxide powder coated with magnesium ferrite (Fe₂MgO₄).

### Comparative Example 1

The powder obtained in Synthesis Example 1 was calcined in air at 1,723 K for 3,600 s, and then further milled by means of a sample mill while controlling the particle size of the resultant powder to be similar to that of the magnesium oxide powder as a raw material, obtaining a coated magnesium oxide powder coated with forsterite (Mg₂SiO₄) .

### Comparative Example 2

Magnesium oxide powder was fed to a high-temperature flame formed by burning of liquefied propane gas and oxygen to obtain a magnesium oxide powder having an uncoated surface.

### Evaluation test

With respect to each of the magnesium oxide powder samples obtained in Examples 1 to 5 and Comparative Examples 1 and 2, an average shape factor, a double oxide content, a BET specific surface area, an average particle size, and a humidity resistance were individually measured, and the results are shown in Table 1. The methods for measurements of the individual items are as follows.

Average shape factor: A particle image was taken using an ultra-depth shape measurement microscope "VK8550" (manufactured by KEYENCE CORPORATION), and shape factors of 100 particles were measured by means of an image analysis software "Easy32" (manufactured by LIBRARY Co. Ltd.) and an average of the values was obtained as an average shape factor.

Double oxide content of powder surface: A content of an element in a powder sample was measured using a scanning fluorescent X-ray analyzer "ZSX-100e" (manufactured by Rigaku Corporation) to determine a double oxide content.

BET specific surface area: A specific surface area of a powder sample was measured using a flow type specific surface area measurement apparatus "FlowSorb II2300" (manufactured by Shimadzu Corporation) in accordance with a gas adsorption method.

Average particle size: A volume average particle size of a powder sample was measured using a particle size distribution measurement apparatus "Microtrac HRA" (manufactured by NIKKISO Co., Ltd.) in accordance with a laser diffraction and scattering method.

Humidity resistance test: 5 × 10⁻³ kg of the sample obtained was stirred in 100 × 10⁻⁶ m³ of boiling water at a temperature of 373 K for 2 hours, and a mass increase rate (mass%) was measured to evaluate a humidity resistance.

**Table 1**

| | Double oxide | | Sphere-shaped coated magnesium oxide | | | |
|---|---|---|---|---|---|---|
| | Type | Content (mass%) | Average shape factor | Average particle size (10⁻⁶ m) | BET specific surface area (10³ m²/kg) | Mass increase rate (mass%) |
| Example 1 | Mg₂SiO₄ | 17.49 | 1.186 | 21.01 | 0.75 | 2.97 |
| Example 2 | Mg₂SiO₄ | 6.56 | 1.242 | 20.24 | 0.54 | 4.12 |
| Example 3 | Mg₂SiO₄ | 48.52 | 1.154 | 21.77 | 0.83 | 1.37 |
| Example 4 | Al₂MgO₄ | 21.76 | 1.194 | 20.45 | 0.78 | 2.77 |
| Example 5 | Fe₂MgO₄ | 21.00 | 1.190 | 20.21 | 0.31 | 1.08 |
| Comparative Example 1 | Mg₂SiO₄ | 18.45 | 1.262 | 20.45 | 0.48 | 3.19 |
| Comparative Example 2 | - | - | 1.289 | 21.09 | 0.81 | 7.34 |

### 2. Resin composition

### Example 6

Epoxysilane in an amount of 1.0 mass% was added to the sample powder prepared in Example 1, and they were mixed with each other by stirring for 600 s to effect a surface treatment for the powder, followed by drying at 423 K for 7,200 s. 560 parts by weight of the resultant sample, 63 parts by weight of an ortho-cresol novolak epoxy resin, 34 parts by weight of a novolak phenolic resin, 1 part by weight of triphenylphosphine, and 2 parts by weight of carnauba wax were mixed together and milled using a mill for 600 s. Then, the resultant mixture was kneaded using a twin roll at 373 K for 300 s, and then the kneaded mixture was further ground into 10 mesh or less to prepare pellets of φ 38 mm × t 15 mm. The pellets were subjected to transfer molding under 7 MPa at 448 K for 180 s, and a spiral flow was measured by the method shown below.

Separately, the pellets were subjected to transfer molding under 7 MPa at 448 K for 180 s, and then subjected to post cure at 453 K for 18 × 10³ s to obtain a molded article of φ 50 mm × t 3 mm.

### Example 7

A spiral flow was measured and a molded article was obtained in substantially the same manner as in Example 6 except that the sphere-shaped coated magnesium oxide powder prepared in Example 2 was used.

### Example 8

A spiral flow was measured and a molded article was obtained in substantially the same manner as in Example 6 except that the sphere-shaped coated magnesium oxide powder prepared in Example 3 was used.

### Example 9

A spiral flow was measured and a molded article was obtained in substantially the same manner as in Example 6 except that the sphere-shaped coated magnesium oxide powder prepared in Example 4 was used.

### Example 10

A spiral flow was measured and a molded article was obtained in substantially the same manner as in Example 6 except that the sphere-shaped coated magnesium oxide powder prepared in Example 5 was used.

### Comparative Example 3

A spiral flow was measured and a molded article was obtained in substantially the same manner as in Example 6 except that the sample prepared in Comparative Example 1 was used.

### Comparative Example 4

A spiral flow was measured and a molded article was obtained in substantially the same manner as in Example 6 except that alumina powder was used instead of the magnesium oxide powder.

### Example 11

Vinyltrimethoxysilane in an amount of 1.0 mass% was added to the sample powder prepared in Example 1, and they were mixed with each other by stirring for 600 s to effect a surface treatment for the powder, followed by drying at 423 K for 7,200 s. 451 parts by weight of the resultant sample and 100 parts by weight of a two-pack RTV silicone rubber were kneaded together using a twin roll for 300 s. Then, 5 parts by weight of a platinum catalyst was added to the kneaded mixture, and they were kneaded using a twin roll for 600 s to prepare a compound, and a viscosity was measured under the conditions shown below. The compound was subjected to press molding under 5 MPa at 393 K for 600 s to obtain a molded article of φ 50 mm × t 3 mm.

### Comparative Example 5

A viscosity was measured and a molded article was obtained in substantially the same manner as in Example 11 except that the sample powder prepared in Comparative Example 1 was used.

### Comparative Example 6

A viscosity was measured and a molded article was obtained in substantially the same manner as in Example 11 except that alumina powder was used instead of the magnesium oxide powder.

### Evaluation test

With respect to each of the resin compositions obtained in Examples 6 to 11 and Comparative Examples 3 to 6, a spiral flow or viscosity (method was appropriately selected depending on the state of the resin at room temperature) was measured, and, with respect to the molded article of each resin composition, a thermal conductivity, a humidity resistance, and appearance after the humidity resistance test were individually measured, and the results are shown in Table 2. The evaluation methods for the individual items are as follows.
Spiral flow: Measured in accordance with EMMI-I-66.
Viscosity: A viscosity was measured using a rheometer "VAR-50" (manufactured by REOLOGICA Instruments AB) at a shear rate of 1 s⁻¹.
Thermal conductivity: A thermal conductivity of a molded article was measured using a thermal constant measurement apparatus "TC-3000" (manufactured by SHINKU-RIKO, Inc.) in accordance with a laser flash method.
Humidity resistance test: A molded article was stored in a thermo-hygrostat at a temperature of 358 K at a humidity of 85% for 7 days, and a moisture absorption rate was measured. Further, the appearance of the resultant molded article was visually inspected.

**Table 2**

| | Double oxide | Resin | Flowability of resin composition | | Evaluation tests of molded article | | |
|---|---|---|---|---|---|---|---|
| | | | Spiral flow (m) | Viscosity (Pa•s) | Thermal conductivity (W/mK) | Moisture absorption rate (mass%) | Appearance after humidity resistance test |
| Example 6 | Mg₂SiO₄ | Epoxy resin | 0.507 | - | 3.11 | 0.18 | No change |
| Example 7 | Mg₂SiO₄ | Epoxy resin | 0.448 | - | 3.25 | 0.20 | No change |
| Example 8 | Mg₂SiO₄ | Epoxy resin | 0.653 | - | 3.03 | 0.11 | No change |
| Example 9 | Al₂MgO₄ | Epoxy resin | 0.535 | - | 3.12 | 0.15 | No change |
| Example 10 | Fe₂MgO₄ | Epoxy resin | 0.492 | - | 3.15 | 0.14 | No change |
| Comparative Example 3 | Mg₂SiO₄ | Epoxy resin | 0.343 | - | 3.18 | 0.17 | No change |
| Comparative Example 4 | -^{(*)} | Epoxy resin | 0.502 | - | 2.78 | 0.15 | No change |
| Example 11 | Mg₂SiO₄ | Silicone rubber | - | 471 | 2.20 | 0.20 | No change |
| Comparative Example 5 | Mg₂SiO₄ | Silicone rubber | - | 3280 | 2.14 | 0.20 | No change |
| Comparative Example 6 | -^{(*)} | Silicone rubber | - | 1130 | 1.70 | 0.16 | No change |

| | | | | | | | |
|---|---|---|---|---|---|---|---|
| (*): Uncoated Al₂O₃ powder was used instead of coated MgO powder. | | | | | | | |

As is apparent from the results shown above, the sphere-shaped coated magnesium oxide powders meeting the average shape factor defined in the present invention (Table 1, Examples 1 to 5) have excellent humidity resistance. Further, it has been confirmed that the resin compositions comprising the above powder (Table 2, Examples 6 to 11) have excellent flowability, and that the molded articles formed from the resin compositions have high thermal conductivity and excellent humidity resistance.

On the other hand, the powder in Comparative Example 1 has excellent humidity resistance, but it has an average shape factor as large as 1.25 or more. Both the epoxy resin containing this powder (Table 2, Comparative Example 3) and the silicone rubber containing this powder (Table 2, Comparative Example 5) had low flowability.

The powder in Comparative Example 2 was not coated with a double oxide and hence, as seen in Table 1, had a very low humidity resistance.

The resin compositions comprising conventional alumina powder instead of the magnesium oxide powder (Table 2, Comparative Examples 4 and 6) had excellent flowability and excellent humidity resistance, but they had poor thermal conductivity.

### Industrial applicability

As described above in detail, the sphere-shaped coated magnesium oxide powder of the present invention has excellent humidity resistance, and further has excellent filling property when being used as filler, and hence can fill a resin with high density, and therefore the powder is advantageously used as thermal conductive filler.

The resin composition comprising the sphere-shaped coated magnesium oxide powder has excellent flowability, and the molded article formed from the resin composition has high heat radiating property and high humidity resistance, and therefore it is remarkably advantageously used as a sealer, a spacer, a bonding agent, or an adhesive sheet for use in a variety of electronic devices, or a constituent member, such as a resin circuit board, a metal base circuit board, a metal-clad laminate, or a metal-clad laminate having an inner circuit, and thus it is highly valuable from a commercial point of view.

## Claims

1. A sphere-shaped coated magnesium oxide powder having a surface coated with a double oxide and having an average shape factor of 1.25 or less.

2. The sphere-shaped coated magnesium oxide powder according to claim 1, wherein said double oxide has a melting point of 2,773 K or lower.

3. The sphere-shaped coated magnesium oxide powder according to claim 2, wherein said double oxide comprises at least one element selected from the group consisting of aluminum, iron, silicon, and titanium, and magnesium.

4. The sphere-shaped coated magnesium oxide powder according to any one of claims 1 to 3, which contains said double oxide in an amount of 5 to 50 mass%.

5. The sphere-shaped coated magnesium oxide powder according to any one of claims 1 to 4, which has an average particle size of 5 × 10⁻⁶ to 500 × 10⁻⁶ m and a BET specific surface area of 5 × 10³ m²/kg or less.

6. A method for producing a sphere-shaped coated magnesium oxide powder, comprising allowing a compound of an element forming a double oxide to be present on the surface of magnesium oxide powder, and then fusing the resultant magnesium oxide powder at a high temperature so that the surface of the magnesium oxide powder is coated with the double oxide and the magnesium oxide powder is shaped into sphere.

7. The method according to claim 6, wherein the compound of the element forming a double oxide together with magnesium is at least one compound selected from the group consisting of an aluminum compound, an iron compound, a silicon compound, and a titanium compound.

8. The method according to claim 6 or 7, wherein the magnesium oxide powder to be coated has a crystallite size of 50 × 10⁻⁹ m or more.

9. The method according to any one of claims 6 to 8, wherein the flame temperature is 2,073 K or higher.

10. A resin composition comprising the sphere-shaped coated magnesium oxide powder according to any one of claims 1 to 5.

11. The resin composition according to claim 10, wherein the resin in the resin composition is an epoxy resin.

12. The resin composition according to claim 10, wherein the resin in the resin composition is a silicone rubber.

13. An electronic device using the resin composition according to any one of claims 10 to 12.
